# EUROPEAN PATENT SPECIFICATION

(11) **EP 0 391 577 B1**
(45) Date of publication and mention of the grant of the patent: **18.11.1993**
(21) Application number: 90303053.4
(22) Date of filing: 21.03.1990
(51) Int. Cl.: H03L 7/183, G01R 21/133, G01R 13/34

(54) **Sampling circuits**
Abtastschaltung
Circuit d'échantillonnage

(30) Priority: 07.04.1989 GB 8907907
(43) Date of publication of application: 10.10.1990
(73) Proprietor: THE GENERAL ELECTRIC COMPANY, p.l.c., London W1A 1EH (GB)
(72) Inventor: Joyce, Timothy Robert, Yarnfield, Stone, Staffordshire (GB); Lester, Gerry, Cannock, Staffordshire (GB)
(74) Representative: Pope, Michael Bertram Wingate

(56) References cited:
- US-A- 4 594 516
- PATENT ABSTRACTS OF JAPAN, vol. 7, no. 264 (E-212)[1409], 24th November 1983; & JP-A-58 145 240 (MATSUSHITA DENKI SANGYO K.K.) 30-08-1983
- PATENT ABSTRACTS OF JAPAN, vol. 6, no. 142 (P-131)[1019], 30th July 1982; & JP-A-57 63 459 (NIHON DENKI K.K.) 16-04-1982
- INTERNATIONALE ELEKTRONISCHE RUNDSCHAU, vol. 26, no. 10, pages 227-231, Berlin, DE; D. MALLON: "Phase-locked loop- eine vielseitig einsetzbare Technik"

## Description

This invention relates to electric signal sampling circuits.

More particularly the invention relates to circuits for sampling periodically varying signals employing a so-called slipping or asynchronous sampling technique.

In a slipping sampling technique the time between successive samples is so chosen that the points-on-wave sampled change for each of a chosen number of successive cycles of the sampled signal, i.e. the time between successive samples is an integral sub-multiple of the total duration of the chosen number of successive cycles of the sampled signal, but a non-integral sub-multiple of the duration of a single cycle of the sampled signal.

It is sometimes required for a sampling circuit to be able to obtain for each sample of a signal being sampled a corresponding sample at a point-on-wave shifted by a desired fraction of a cycle of the signal being sampled.

It is often difficult to provide this facility when using a slipping sampling technique and it is an object of the present invention to provide a sampling circuit which overcomes this difficulty.

According to the present invention there is provided a circuit for sampling periodic electric signals of frequency F comprising: circuit means for producing first and second synchronised periodic signals of frequency PF/M and KPFN respectively, where K is an integer, P and M are relatively prime plural integers, P is greater than M and 1/N is a desired phase shift between two sets of samples to be produced by the circuit expressed as a fraction of a cycle of a sampled signal; first sampling means for utilising said first periodic signal to control sampling of a signal at the frequency of said first periodic signal; and second sampling means for utilising every KPth cycle of said second periodic signal before or after a sampling effected by the first sampling means to control sampling of a signal at the frequency of the first periodic signal at points-on-wave phase shifted with respect to the points-on-wave sampled by the first sampling means.

Two sampling circuits in accordance with the invention will now be described by way of example with reference to the accompanying drawings in which:-
Figure 1 is a schematic diagram of a known electric energy consumption measuring device incorporating a slipping sampling circuit;
Figure 2 is a schematic diagram of an electric energy consumption measuring device incorporating a first sampling circuit according to the invention;
Figure 3A to 3D are waveforms illustrating the operation of the sampling circuit of Figure 2; and
Figure 4 is a schematic diagram of an electric energy consumption meter incorporating a second sampling circuit according to the invention.

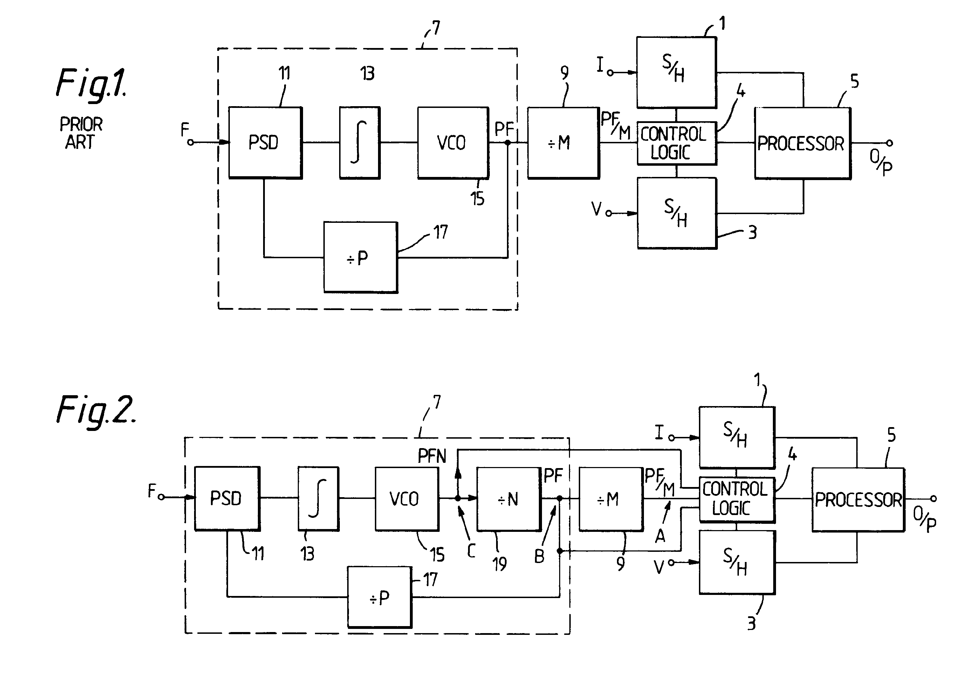

Referring to Figure 1, in a known arrangement for measuring the consumption of real electric energy in a load (not shown) connected to an alternating current supply (not shown), the instantaneous value of the current I and voltage V supplied to the load are repeatedly sampled by sample and hold circuits 1 and 3 respectively under the control of logic circuits 4. The samples obtained are passed to a processor circuit 5 wherein the product of each pair of contemporary current and voltage samples is obtained and the products integrated over a period of time to obtain a measure of consumed energy during the period.

The current and voltage samples are obtained using a slipping sampling technique. To this end timing signals for controlling operation of the sample and hold circuits 1 and 3 are obtained by means of a phase locked loop (PLL) 7 and a frequency divider 9 of division factor M. The PLL 7 comprises a phase sensitive detector (PSD) 11 to one input of which is applied a rectangular waveform pulse signal of frequency F equal to the frequency of the alternating voltage supplied to the load. The output of the PSD 11 is integrated in an integrator 13 and the output of the integrator 13 used to control the frequency of a voltage controlled oscillator (VCO) 15. The output of the VCO 15 is applied to the other input of the PSD 11 via a frequency divider 17 of division factor P. The frequency of the output of the VCO 15 thus assumes a value PF locked to the supply frequency F.

The output of the VCO 15 is also supplied via the divider 9 to the control logic 4 of sample and hold circuits 1 and 3 to provide timing signals of frequency PF/M for controlling the sampling rate. The number of samples of voltage and current taken during each cycle of the alternating current supply to the load is thus P/M, i.e. P samples are taken over every M cycles of the supply, and the angle between successive sample points is 360 M/P°. To obtain slipping sampling with several samples during each supply cycle P is chosen to be several times greater than M, and P and M are made relatively prime.

In energy measuring devices it is sometimes required to measure reactive energy. This may be achieved by integrating the products of instantaneous voltage and current samples respectively taken at points separated by 90° i.e. samples respectively taken at times differing by the duration of a quarter of a cycle of the supply waveform.

Such samples, or indeed samples separated by any desired fraction 1/N of a cycle of the signal of frequency F applied to PLL 7, may be obtained in accordance with the invention by a modification of the sampling circuit of Figure 1. As shown in Figure 2, the modification comprises inserting between the VCO 15 and the divider 17 a frequency divider 19 of division factor N, the input to the divider 9 being then taken from the junction between the dividers 19 and 17. In addition, the output of VCO 15 and divider 19 are applied to the control logic 4 of sample and hold circuits 1 and 3.

With the arrangement of Figure 2 the frequency of the output of the divider 9 is PF/M, as was the case before the modification. Hence, simultaneous slipping sampling of current and voltage by sample and hold circuits 1 and 3 under control of the signals at the output of the divider 9 can still take place, when required, as with the Figure 1 arrangement.

The output signal of the VCO 15 is now of frequency PFN so that PN pulses appear at the output of the VCO 15 during each cycle of the signal of frequency F. Thus P pulses appear at the output of the VCO 15 during each fraction 1/N of a cycle of the signal of frequency F. Hence, the signals at the output of VCO 15, divider 19 and divider 9 can together be utilised, when required, to obtain sampling of the voltage V by sample and hold circuit 3 at points-on-wave which are 1/N of a cycle from the points-on-wave at which the current waveform is sampled by sample and hold circuit 1, thereby enabling computation of reactive power by the processing circuit 5.

It will be appreciated that this is achieved regardless of the values of M and P, thus allowing these values to be chosen with a view to obtaining, for example, a desired number of samples per cycle of the sampled signal, a desired degree of slipping during sampling, or to minimise the number of stages employed in the dividers 9, 17 and 19. Furthermore the required phase shifted sampling is obtained independently of the value of F.

In one particular embodiment of the arrangement of Figure 2, for measuring the energy supplied to a load from a 50 Hz alternating current supply, N, M and P have values of 4, 16 and 97 respectively.

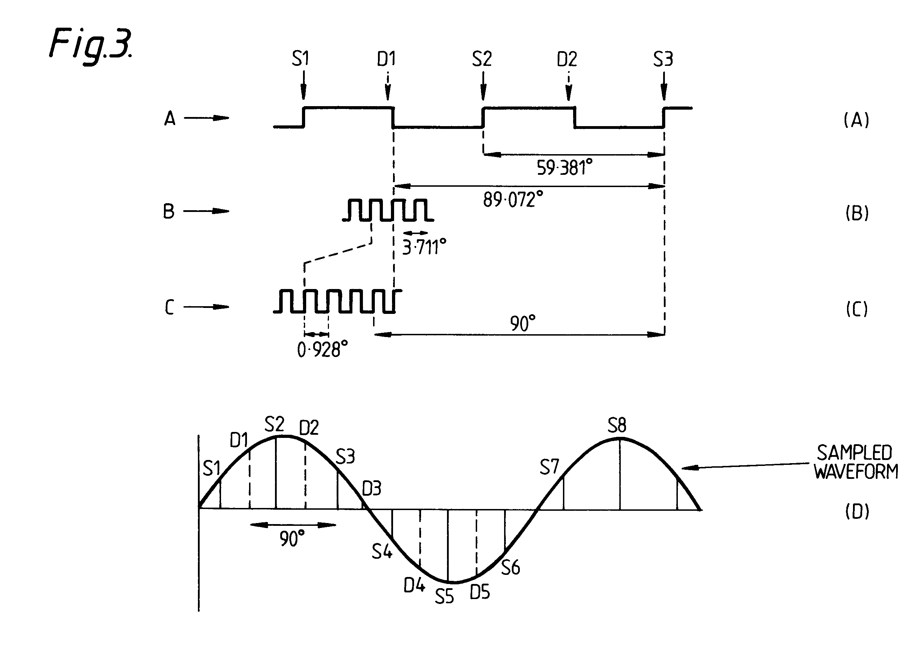

The waveforms of the signals appearing at points A, B and C in Figure 2 with these values for N, M, P and F are shown in Figures 3A, 3B and 3C respectively. For the purpose of explanation it is assumed that for measurement of real power sampling of both voltage V and current I takes place at each positive-going edge S1, S2, etc. of the signal at point A, as indicated in Figures 3A and 3D. Since 4 x 97 pulses occur at point C during each cycle of the sampled signal, the 97th positive-going edge occurring at point C before or after each positive-going edge S in the signal at point A must occur at a point-on-wave of the sampled signal phase-shifted exactly by 90° from the point-on-wave at which that positive-going edge S occurred. Thus, for measurement of reactive energy, instead of sampling voltage V at each positive-going edge of the signal at point A, the voltage V is sampled at each 97th positive-going edge of the signal at point S occurring before or after each positive-going edge in the signal at point S corresponding to a positive-going edge S in the signal at point A.

This is further illustrated in Figures 3A to 3D where sampling times D1, D2, D3 etc. lead sampling times S3, S4, S5 etc. respectively by 90° exactly, and the phase angles corresponding to a cycle of the signals at each of points A, B and C is shown. Thus, as shown in Figure 3A the angle between successive positive-going edges S of the signal at point A is 360° x 16/97 = 59.381°. Similarly, as shown in Figure 3B and 3C, the angles between successive positive-going edges of the signals at points B and C are 59.381° 16 ÷ 3.711° and 3.711° ÷ 4 = 0.928° respectively, and edge D1 in signal C leads edge S3 in signal A by 97 x 0.928° = 90°.

It will be understood that the divider 19 may have a division factor of any value KN where K is an integer, the required phase-shifted samples of voltage V then being taken at times corresponding to each KPth pulse edge at point C before or after each pulse edge at point A at which a sample of current I is taken.

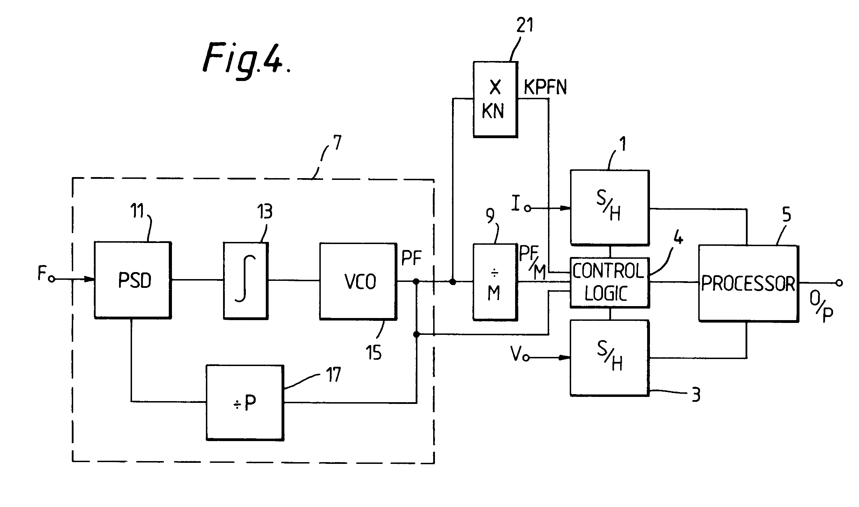

It will further be understood that instead of inserting divider 19 between VCO 15 and divider 17 of Figure 1 to produce the signal of frequency KPNF at point C for use by the control logic 4, a frequency multiplier 21 of multiplying factor KN may be connected to the junction between VCO 15 and divider 9 of Figure 1, as illustrated in Figure 4.

## Claims

1. A circuit for sampling a periodic electric signal of frequency F comprising: circuit means (9, 11, 13, 15, 17, 19 or 21) for producing first and second synchronised periodic signals of frequencies PF/M and KPFN respectively, where K is an integer, P and M are relatively prime plural integers, P is greater than M and 1/N is a desired phase shift between two sets of samples to be produced by the circuit expressed as a fraction of a cycle of a sampled signal; first sampling means (1, 4 or 3, 4) for utilising said first periodic signal to control sampling of a signal (I or V) at the frequency of said first periodic signal; and second sampling means (3, 4) for utilising every KPth cycle of said second periodic signal before or after a sampling effected by the first sampling means (1, 4 or 3, 4) to control sampling of a signal (V) at the frequency of the first periodic signal at points-on-wave phase shifted with respect to the points-on-wave sampled by the first sampling means (1, 4 or 3,4).

2. A circuit according to Claim 1 wherein P is a prime number.

3. A circuit according to Claim 1 or Claim 2 wherein said circuit means (9, 11, 13, 15, 17, 19 or 21) comprises a phase locked loop arrangement (11, 13, 15, 17, 19).

4. A circuit according to Claim 3 wherein said phase locked loop arrangement (11, 13, 15, 17, 19) comprises: a phase sensitive detector (11) having a first input to which a signal of frequency F is applied; a voltage controlled oscillator (15) whose frequency is controlled in dependence on the output of said detector (11); first and second divider circuits (19 and 17) of division factors KN and P respectively connected in series in the order stated between the output of the oscillator (15) and a second input of the detector (11); and said circuit means (9, 11, 13, 15, 17, 19) further includes a third frequency divider circuit (9) of division factor M connected to the junction between the first and second dividers (19 and 17); said first sampling means (1, 4 or 3, 4) being controlled in dependence on the signal at the output of said third divider (9), and said second sampling means (3, 4) being controlled in dependence on the signals at the outputs of said oscillator (15) and said third divider (9).

5. A circuit according to Claim 3 wherein said phase locked loop arrangement (11, 13, 15, 17) comprises: a phase sensitive detector (11) having a first input to which a signal of frequency F is applied; a voltage controlled oscillator (15) whose frequency is controlled in dependence on the output of said detector (11); a first frequency divider circuit (17) of division factor P connected between the output of the oscillator (15) and a second input of the detector (11); and said circuit means (9, 11, 13, 15, 17, 21) further includes a second frequency divider (9) of division factor M connected to the junction between the oscillator (15) and the first divider (17); and a frequency multiplier (21) of multiplication factor KN connected to the junction between the oscillator (15) and the first divider (17); said first sampling means (1, 4, or 3, 4) being controlled in dependence on an output signal of said second divider (9) and said second sampling means (3, 4) being controlled in dependence on output signals of said second divider (9) and said multiplier (21).

6. A circuit according to any one of the preceding claims wherein N has a value 4 such that the sampling effected by said second sampling means (3, 4) is phase shifted with respect to the sampling effected by said first sampling means (1, 4 or 3, 4) by 90°.

7. A circuit according to Claim 6 wherein P has a value of 97 and M has a value of 16.

8. A device for measuring reactive electric energy consumed in a load supplied from an alternating current supply comprising: a sampling circuit according to Claim 6 or Claim 7 arranged to produce samples of the instantaneous values of the current and voltage supplied to the load phase shifted by 90°; and means (5) for integrating the products of pairs of the voltage and current samples.

## Patentansprüche

1. Schaltung zum Abtasten eines periodischen elektrischen Signals einer Frequenz F, aufweisend: eine Schaltungseinrichtung (9, 11, 13, 15, 19 oder 21) zum Erzeugen erster und zweiter synchronisierter periodischer Signale mit Frequenzen PF/M bzw. KPFN, wobei K eine ganze Zahl ist, P und M im Verhältnis teilerfremde plurale ganze Zahlen sind, P größer als M ist und 1/N eine gewünschte Phasenschiebung zwischen zwei Sätzen von der Schaltung zu erzeugender Abtastwerte, ausgedrückt als Bruchteil von einer Periode eines abgetasteten Signals, ist; eine erste Abtasteinrichtung (1, 4 oder 3, 4), die das erste periodische Signal zur Steuerung der Abtastung eines Signals (I oder V) bei der Frequenz des ersten periodischen Signals benutzt; und eine zweite Abtasteinrichtung (3, 4), die jede KPte Periode des zweiten periodischen Signals vor oder nach einer durch die erste Abtasteinrichtung (1, 4 oder 3, 4) bewerkstelligten Abtastung zur Steuerung der Abtastung eines Signals (V) bei der Frequenz des ersten periodischen Signals an Punkten auf der Welle, die bezüglich den von der ersten Abtasteinrichtung (1, 4 oder 3, 4) abgetasteten Punkten auf der Welle phasenverschoben sind, benutzt.

2. Schaltung nach Anspruch 1, in welcher P eine Primzahl ist.

3. Schaltung nach Anspruch 1 oder Anspruch 2, in welcher die Schaltungseinrichtung (9, 11, 13, 15, 17, 19 oder 21) eine Phasenregelkreisanordnung (11, 13, 15, 17, 19) aufweist.

4. Schaltung nach Anspruch 3, in welcher die Phasenregelkreisanordnung (11, 13, 15, 17, 19) aufweist: einen phasensensitiven Detektor (11), der einen ersten Eingang aufweist, dem ein Signal der Frequenz F zugeführt wird; einen spannungsgesteuerten Oszillator (15), dessen Frequenz abhängig vom Ausgangssignal des Detektors (11) gesteuert wird; eine erste und zweite Teilerschaltung (19 und 17) mit Teilerfaktoren KN bzw. P, wobei diese Schaltungen in der zwischen dem Ausgang des Oszillators (15) und einem zweiten Eingang des Detektors (11) festgelegten Reihenfolge in Serie geschaltet sind: und die Schaltungseinrichtung (9, 11, 13, 15, 17, 19) ferner eine dritte Frequenzteilerschaltung (9) mit einem Teilerfaktor M aufweist, die mit dem Verbindungspunkt zwischen dem ersten und zweiten Teiler (19 und 17) verbunden ist; wobei die erste Abtasteinrichtung (1, 4 oder 3, 4) in Abhängigkeit vom Signal am Ausgang des dritten Teilers (9) gesteuert wird und die zweite Abtasteinrichtung (3, 4) in Abhängigkeit von den Signalen an den Ausgängen des Oszillators (15) und des dritten Teilers (9) gesteuert wird.

5. Schaltung nach Anspruch 3, in welcher die Phasenregelkreisanordnung (11, 13, 15, 17) umfaßt: einen phasensensitiven Detektor (11), der einen ersten Eingang aufweist, dem ein Signal der Frequenz F zugeführt wird; einen spannungsgesteuerten Oszillator (15), dessen Frequenz abhängig vom Ausgangssignal des Detektors (11) gesteuert wird; eine erste Frequenzteilerschaltung (17) mit einem Teilerfaktor P, die zwischen dem Ausgang des Oszillators (15) und einem zweiten Eingang des Detektors (11) geschaltet ist; und in welcher die Schaltungseinrichtung (9, 11, 13, 15, 17, 21) ferner einen zweiten Frequenzteiler (9) mit einem Teilerfaktor M aufweist, wobei dieser Teiler mit dem Verbindungspunkt zwischen dem Oszillator (15) und dem ersten Teiler (17) verbunden ist; und einen mit dem Verbindungspunkt zwischen dem Oszillator (15) und dem ersten Teiler (17) verbundenen Frequenzmultiplikator (21) mit einem Multiplikationsfaktor KN; wobei die erste Abtasteinrichtung (1, 4 oder 3, 4) in Abhängigkeit von einem Ausgangssignal des zweiten Teilers (9) gesteuert wird und die zweite Abtasteinrichtung (3, 4) in Abhängigkeit von Ausgangssignalen des zweiten Teilers (9) und des Multiplikators (21) gesteuert wird.

6. Schaltung nach einem der vorhergehenden Ansprüche, in welcher N einen Wert 4 aufweist, derart, daß die von der zweiten Abtasteinrichtung (3, 4) durchgeführte Abtastung bezüglich der von der ersten Abtasteinrichtung (1, 4 oder 3, 4) durchgeführten Abtastung um 90° phasenverschoben ist.

7. Schaltung nach Anspruch 6, in welcher P einen Wert von 97 aufweist und M einen Wert von 16.

8. Vorrichtung zur Messung der verbrauchten elektrischen Blindenergie in einer aus einer Wechselstromversorgung gespeisten Last, aufweisend: eine Abtastschaltung nach Anspruch 6 oder 7, dazu ausgelegt, Abtastwerte der Momentanwerte des Stromes und der Spannung, die der Last zugeführt werden, um 90° phasenverschoben zu erzeugen, und eine Einrichtung (5) zum Integrieren der Produktpaare der Spannungs- und Stromabtastwerte.

## Revendications

1. Circuit d'échantillonnage d'un signal électrique périodique de fréquence F, comprenant un dispositif à circuit (9, 11, 13, 15, 17, 19 ou 21) destiné à créer des premier et second signaux périodiques synchronisés de fréquences PF/M et KPFN respectivement, K étant un nombre entier, P et M étant des nombres entiers premiers l'un par rapport à l'autre, P étant supérieur à M et 1/N étant un déphasage nécessaire entre deux ensembles d'échantillons qui doivent être produits par le circuit, exprimé sous forme d'une fraction d'un cycle d'un signal échantillonné, un premier dispositif d'échantillonnage (1, 4 ou 3, 4) destiné à utiliser le premier signal périodique pour la commande de l'échantillonnage d'un signal (I ou V) à la fréquence du premier signal périodique, et un second dispositif d'échantillonnage (3, 4) destiné à utiliser chaque KPième cycle du cycle du second signal périodique avant ou après un échantillonnage réalisé par le premier dispositif d'échantillonnage (1, 4 ou 3, 4) pour la commande de l'échantillonnage d'un signal (V) à la fréquence du premier signal périodique en des points de l'onde qui sont déphasés par rapport aux points de l'onde échantillonnés par le premier dispositif d'échantillonnage (1, 4 ou 3, 4).

2. Circuit selon la revendication 1, dans lequel P est un nombre premier.

3. Circuit selon la revendication 1 ou 2, dans lequel le dispositif à circuit (9, 11, 13, 15, 17, 19 ou 21) comprend un ensemble à boucle à phase verrouillée (11, 13, 15, 17, 19).

4. Circuit selon la revendication 3, dans lequel l'ensemble à boucle à phase verrouillée (11, 13, 15, 17, 19) comprend un détecteur (11) sensible à la phase ayant une première entrée à laquelle est appliqué un signal de fréquence F, un oscillateur (15) commandé en tension dont la fréquence est réglée d'après le signal de sortie du détecteur (11), un premier et un second circuit diviseur (19 et 17) ayant des facteurs de division KN et P respectivement, connectés en série dans l'ordre indiqué entre la sortie de l'oscillateur (15) et une seconde entrée du détecteur (11), et le dispositif à circuit (9, 11, 13, 15, 17, 19) comporte en outre un troisième circuit diviseur de fréquence (9) ayant un facteur de division M connecté à la connexion du premier et du second circuit diviseur (19 et 17), le premier dispositif d'échantillonnage (1, 4 ou 3, 4) étant commandé d'après le signal de sortie du troisième diviseur (9), et le second dispositif d'échantillonnage (3, 4) étant commandé d'après les signaux de sortie de l'oscillateur (15) et du troisième circuit diviseur (9).

5. Circuit selon la revendication 3, dans lequel l'ensemble à boucle à phase verrouillée (11, 13, 15, 17) comporte un détecteur (11) sensible à la phase à une première entrée duquel est appliqué un signal de fréquence F, un oscillateur commandé en tension (15) dont la fréquence est réglée par le signal de sortie du détecteur (11), et un premier circuit diviseur de fréquence (17) ayant un facteur de division P, connecté entre la sortie de l'oscillateur (15) et une seconde entrée du détecteur (11), et le dispositif à circuit (9, 11, 13, 15, 17, 21) comporte en outre un second diviseur de fréquence (9) ayant un facteur de division M, connecté à la connexion formée entre l'oscillateur (15) et le premier diviseur (17), et un circuit multiplicateur de fréquence (21) ayant un facteur de multiplication KN, connecté à la connexion de l'oscillateur (15) et du premier diviseur (17), le premier dispositif d'échantillonnage (1, 4 ou 3, 4) étant commandé par le signal de sortie du second circuit diviseur (9) et le second dispositif d'échantillonnage (3, 4) étant commandé par les signaux de sortie du second circuit diviseur (9) et du circuit multiplicateur (21).

6. Circuit selon l'une quelconque des revendications précédentes, dans lequel N a une valeur égale à 4, si bien que l'échantillonnage réalisé par le second dispositif d'échantillonnage (3, 4) subit un déphasage de 90° par rapport à l'échantillonnage réalisé par le premier dispositif d'échantillonnage (1, 4 ou 3, 4).

7. Circuit selon la revendication 6, dans lequel P a une valeur égale à 97 et M a une valeur égale à 16.

8. Appareil de mesure de l'énergie électrique réactive consommée par une charge qui est reliée à une alimentation en courant alternatif, comprenant un circuit d'échantillonnage selon la revendication 6 ou 7, destiné à produire des échantillons des valeurs instantanées du courant et de la tension transmis à la charge, avec un déphasage de 90°, et un dispositif (5) d'intégration des produits de paires d'échantillons de tension et de courant.
